# EUROPÄISCHE PATENTSCHRIFT

(11) **EP 2 791 972 B1**
(45) Veröffentlichungstag und Bekanntmachung des Hinweises auf die Patenterteilung: **24.07.2019**
(21) Anmeldenummer: 12798212.2
(22) Anmeldetag: 21.11.2012
(51) Int. Cl.: H01L 25/16

(54) **LEISTUNGSMODUL FÜR EINE ELEKTRISCHE MASCHINE**
POWER MODULE FOR AN ELECTRICAL MACHINE
MODULE À PUISSANCE POUR UNE MACHINE ÉLECTRIQUE

(30) Priorität: 12.12.2011 DE 102011088250
(43) Veröffentlichungstag der Anmeldung: 22.10.2014
(73) Patentinhaber: Robert Bosch GmbH, 70442 Stuttgart (DE)
(72) Erfinder: SCHNEIDER, Norbert, 71272 Renningen-Malmsheim (DE); SCHOENKNECHT, Andreas, 71272 Renningen (DE); ADAM, Boris, 71126 Gaeufelden (DE); KLUTHE, Christian, 70771 Leinfelden-Echterdingen (DE)
(86) Internationale Anmeldenummer: PCT/EP2012/073214
(87) Internationale Veröffentlichungsnummer: WO 2013/087382

(56) Entgegenhaltungen:
- EP-A1- 2 487 711
- WO-A1-00/21187
- DE-A1- 10 344 633
- DE-A1-102004 052 287
- JP-A- 2007 215 396
- JP-A- 2011 077 464
- US-A1- 2005 161 785
- US-A1- 2009 219 696
- US-A1- 2010 008 018

## Beschreibung

### Stand der Technik

Die Erfindung betrifft ein Leistungsmodul für eine elektrische Maschine, insbesondere eine elektrische Maschine eines Elektrofahrzeuges. Das Leistungsmodul weist eine Leistungsendstufe auf, wobei die Leistungsendstufe zwei Halbleiterschalter umfasst.

Aus der EP 2 487 711 ist eine Leistungsumformeinheit mit einem Halbleitermodul bekannt, bei der Halbleiterelemente über Stromschienen kontaktiert sind und das Halbleitermodul mit Harz verschlossen ist.

Aus der US 2005 016 1785 ist ein Halbleitermodul bekannt, bei der Leistungs-MOS-FET über deren Oberflächen von plattenähnlichen Kontakten kontaktiert sind.

Aus der US 2010 0008018 ist ein Kondensatorsegment für ein Fahrzeug bekannt, bei dem Kondensatoren über L-förmige Verbinder kontaktiert sind.

### Offenbarung der Erfindung

Erfindungsgemäß umfasst das Leistungsmodul der eingangs genannten Art einen elektrischen Energiespeicher. Die Leistungsendstufe ist eingangsseitig mit dem elektrischen Energiespeicher verbunden. Der Energiespeicher weist einen positiven Anschluss und einen negativen Anschluss auf, wobei der Energiespeicher mit dem positiven Anschluss mit einer positiven Kontaktschiene und mit dem negativen Anschluss mit einer negativen Kontaktschiene verbunden ist, wobei wenigstens ein Flächenabschnitt der Kontaktschienen jeweils mit einem Anschluss, insbesondere einer Anschlussfläche des wenigstens einen der Halbleiterschalter elektrisch verbunden ist. Bevorzugt ist der Flächenabschnitt mit der Anschlussfläche des Halbleiterschalters mittels Löten elektrisch verbunden.

Durch die so gebildete Anordnung kann die Leistungsendstufe zusammen mit dem Energiespeicher, beispielsweise einem Kondensator, insbesondere einem Zwischenkreiskondensator, oder wenigstens einen Akkumulator, eine kompakte Baueinheit bilden. Weiter vorteilhaft können so elektrische Anschlusswege zwischen dem Energiespeicher und der Leistungsendstufe kurz, und damit niederohmig und auch mit einer niedrigen Induktivität ausgeführt sein.

Erfindungsgemäß schließen die positive Kontaktschiene und die negative Kontaktschiene einen Hohlraum ein, in dem der Energiespeicher wenigstens teilweise oder vollständig aufgenommen ist.

Erfindungsgemäß ist mittels der Kontaktschienen eine Rinne gebildet, wobei der Energiespeicher wenigstens teilweise oder vollständig in der Rinne aufgenommen ist. Durch die so gebildete Anordnung kann der Energiespeicher vorteilhaft mittels der Kontaktschienen sowohl mechanisch gehalten als ach elektrisch kontaktiert sein. Der positive Anschluss und der negative Anschluss des Energiespeichers ist dazu bevorzugt jeweils als elektrisch leitfähige Schicht, insbesondere als Schoopschicht ausgebildet. Die Kontaktschienen sind jeweils bevorzugt an mehreren Kontaktorten mit der elektrisch leitfähigen Schicht verbunden. Die Kontaktschiene ist erfindungsgemäß als elektrisch leitfähiges Blech, insbesondere Kupferblech ausgebildet. Die Kontaktschiene ist beispielsweise mittels Schweißen oder Löten an den Kontaktorten mit der elektrisch leitfähigen Schicht verbunden.

In einer bevorzugten Ausführungsform des Leistungsmoduls ist der Flächenabschnitt der Kontaktschiene durch einen entlang einer Längserstreckung der Kontaktschiene abgewinkelten Abschnitt der Kontaktschiene gebildet. So kann vorteilhaft mittels der positiven und der negativen Kontaktschiene die vorab beschriebene Rinne gebildet sein.

In einer bevorzugten Ausführungsform des Leistungsmoduls überlappen die Kontaktschienen jeweils mit dem Flächenabschnitt zueinander beabstandet und schließen miteinander einen Zwischenraum ein. Bevorzugt ist der wenigstens eine Halbleiterschalter in dem Zwischenraum eingeschlossen, wobei wenigstens ein Anschluss des Halbleiterschalters mit wenigstens einer Stromschiene elektrisch leitfähig verbunden ist. So kann vorteilhaft eine niederohmige Verbindung durch den abgewinkelten Flächenabschnitt der Kontaktschiene zu dem Halbleiterschalter hin gebildet sein. Erfindungsgemäß bildet der abgewinkelte Flächenabschnitt sowohl einen Rinnenboden der zuvor erwähnten Rinne, in welcher der Energiespeieher aufgenommen ist, als auch eine elektrische Verbindungsleitung zu dem Halbleiterschalter hin.

Erfindungsgemäß weist die Leistungsendstufe zwei Halbleiterschalter auf, welche gemeinsam eine Halbbrücke bilden, wobei ein Highside-Halbleiterschalter der Halbbrücke mit einem Anschluss mit dem Flächenabschnitt der positiven Kontaktschiene verbunden ist und ein Lowside-Halbleiterschalter der Halbbrücke mit dem Flächenabschnitt der negativen Kontaktschiene verbunden ist. So ist vorteilhaft eine Halbbrücke in dem Leistungsmodul gemeinsam mit einem Zwischenkreiskondensator integriert. Vorteilhaft kann das Leistungsmodul mit weiteren Leistungsmodulen, welche jeweils einen Energiespeicher und eine Halbbrücke aufweisen, eine Leistungseinheit bilden.

Die Leistungseinheit ist bevorzugt mit einem Stator einer elektrischen Maschine verbunden, wobei der Stator der elektrischen Maschine beispielsweise drei Statorspulen aufweist. Bevorzugt weist die Leistungseinheit für jede Statorspule des Stators ein Leistungsmodul auf, wobei das Leistungsmodul ausgangsseitig mit der Statorspule verbunden ist.

Erfindungsgemäß weist das Leistungsmodul einen Ausgangsanschluss auf, der mit einem Ausgang der Halbbrücke verbunden ist, wobei der Ausgangsanschluss mit einem Flächenabschnitt mit dem Highside-Halbleiterschalter verbunden ist und mit demselben oder einem weiteren Flächenabschnitt mit dem Lowside-Halbleiterschalter verbunden ist. Der Highside-Halbleiterschalter ist zwischen dem Flächenabschnitt des Ausgangsanschlusses und dem Flächenabschnitt der positiven Kontaktschiene angeordnet, wobei der Lowside-Halbleiterschalter zwischen dem weiteren Flächenabschnitt des Ausgangsanschlusses und dem Flächenabschnitt der negativen Kontaktschiene angeordnet ist. So können die Halbleiterschalter vorteilhaft in einer gemeinsamen Ebene angeordnet sein, sodass die Leistungsendstufe zusammen mit dem Energiespeicher eine kompakte, insbesondere bauraumeffizient gestaltete Einheit bildet.

Erfindungsgemäß sind die Anschlüsse des Halbleiterschalters, insbesondere die Anschlüsse der Schaltstrecke des Halbleiterschalters, jeweils durch einander gegenüberliegende, weiter bevorzugt zueinander parallele Oberflächenbereiche des Halbleiterschalters gebildet. Bevorzugt ist der Halbleiterschalter ein Feldeffekttransistor, insbesondere ein MIS-FET-Transistor (MIS-FET = Metal-Insulated-Semiconductor-Field-Effect-Transistor), ein MOS-FET-Transistor (MOS = Metal-Oxide-Semiconductor) oder ein IGBT (IGBT = Insulated-Gate-Bipolar-Transistor). Der Halbleiterschalter ist erfindungsgemäß durch einen gehäuselosen Halbleiterschalter, auch Bare-Die genannt, gebildet. Bevorzugt weist der Gehäuselose Halbleiterschalter elektrische Anschlüsse auf, die jeweils durch einen metallisierten Oberflächenbereich des Halbleiterschalters gebildet sind.

Erfindungsgemäß weist der gehäuselose Halbleiterschalter eine Quaderform auf. Dadurch kann der Halbleiterschalter vorteilhaft in einen Sandwichverbund umfassend die Flächenabschnitte der bereits erwähnten Kontaktschienen eingeschlossen sein.

In einer bevorzugten Ausführungsform ist das Leistungsmodul mit einem Kühlelement wärmeleitend verbunden. Bevorzugt ist wenigstens ein Flächenabschnitt einer Kontaktschiene oder zusätzlich ein Flächenabschnitt des Ausgangsanschlusses mit dem Kühlelement wärmeleitend verbunden. So kann vorteilhaft sowohl von dem Energiespeicher über die elektrisch leitfähigen Kontaktschienen Wärme in das Kühlelement abgeführt werden, als auch von der Leistungsendstufe über die Flächenabschnitte der Kontaktschienen Wärme in das Kühlelement fließen.

In einer bevorzugten Ausführungsform umfasst das Leistungsmodul wenigstens eine Diode, welche zu einer Schaltstrecke des Halbleiterschalters parallel geschaltet ist. Die Diode ist bevorzugt eine Gleichrichterdiode. Dadurch kann bei einem Elektromotorischen Antrieb in einem Rekuperationsbetrieb elektrische Energie in den Energiespeicher zurückgespeist werden.

Es ist auch einen elektromotorischen Antrieb offenbart, der einen Elektromotor und wenigstens ein Leistungsmodul der vorbeschriebenen Art umfasst, wobei das Leistungsmodul ausgangsseitig mit wenigstens einer Statorspule des Elektromotors verbunden ist.

Der elektromotorische Antrieb ist bevorzugt Bestandteil eines Elektrofahrzeuges. Weitere vorteilhafte Anwendungen für das Leistungsmodul sind eine Photovoltaikanlage umfassend wenigstens ein Photovoltaikmodul mit einem Wechselrichter, wobei der Wechselrichter wenigstens ein Leistungsmodul der vorbeschriebenen Art aufweist.

Vorteilhaft kann bei den vorbeschriebenen Vorrichtungen eine Leistungseinheit modular mit wenigstens einem oder mehreren Leistungsmodulen bereitgestellt werden. Die Leistungsmodule können beispielsweise jeweils ausgebildet sein, trennbar oder untrennbar, miteinander zu einer Leistungseinheit verbunden zu werden. Dazu kann das Leistungsmodul beispielsweise eine Steckverbindung zu einer Stromschiene hin aufweisen.

Die Erfindung wird nun im Folgenden anhand von Figuren und weiteren Ausführungsbeispielen beschrieben. Weitere vorteilhafte Ausführungsvarianten ergeben sich aus den Merkmalen der abhängigen Ansprüche und den Merkmalen der Figuren.
Figur 1 zeigt - schematisch - ein Ausführungsbeispiel für ein Leistungsmodul mit zwei Energiespeichern, welche jeweils mit einer Halbbrücke umfassend zwei Halbleiterschalter zu einem Leistungsblock verbunden sind;
Figur 2 zeigt das in Figur 1 gezeigte Leistungsmodulen einer Variante in einer Schnittdarstellung;
Figur 3 zeigt eine Variante eines Leistungsmoduls in einer Schnittdarstellung, bei dem Halbleiterschalter einer Halbbrücke von Kontaktschienenabschnitten eingeschlossen sind.

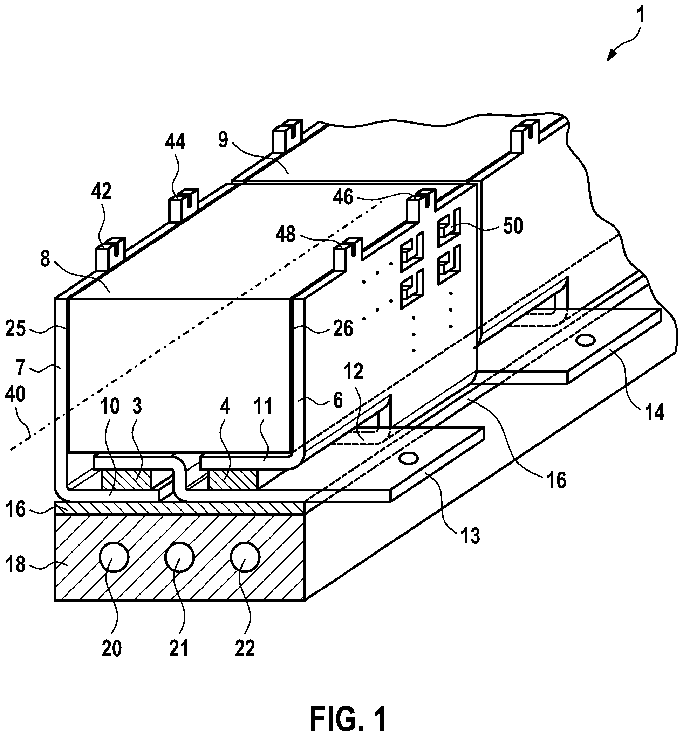

Figur 1 zeigt ein Ausführungsbeispiel für ein Leistungsmodul 1. Das Leistungsmodul 1 weist zwei Halbleiterschalter 3 und 4 auf. Das Leistungsmodul 1 weist auch eine negative Kontaktschiene 6 und eine positive Kontaktschiene 7 auf. Die Kontaktschienen 6 und 7 sind jeweils aus Blech gebildet. Die negative Kontaktschiene 6 weist einen entlang einer Längserstreckung 40 des Leistungsmoduls 1 abgewinkelten Flächenabschnitt 11 auf. Der Flächenabschnitt 11 steht mit dem Halbleiterschalter 4, insbesondere einem Source-Anschluss des Halbleiterschalters 4, der durch einen Oberflächenbereich des Halbleiterschalters 4 gebildet ist, in elektrischer Wirkverbindung. Der Flächenabschnitt 11 ist in diesem Ausführungsbeispiel mit dem Source-Anschluss des Halbleiterschalters 4 mittels Löten verbunden.

Die positive Kontaktschiene 7 weist einen entlang der Längserstreckung 40 abgewinkelten Flächenbereich 10 auf. Der Flächenabschnitt 10 ist mit einem Drain-Anschluss des Halbleiterschalters 3, insbesondere mittels Löten elektrisch verbunden. Der Drain-Anschluss des Halbleiterschalters 3 ist durch einen Oberflächenbereich des Halbleiterschalters 3 gebildet.

Das Leistungsmodul 1 weist auch einen Ausgangsanschluss 13 einer mittels der Halbleiterschalter 3 und 4 gebildeten Halbbrücke, insbesondere Transistor-Halbbrücke auf. Der Ausgangsanschluss 13 ist durch ein Blech gebildet, welches in diesem Ausführungsbeispiel treppenförmig abgewinkelt ist. Eine so gebildete Treppenstufe des Ausgangsanschlusses 13 liegt dem Flächenabschnitt 10 parallel gegenüber und schließt den Halbleiterschalter 3 zusammen mit dem Flächenabschnitt 10 in einem Zwischenraum ein. Der Ausgangsanschluss 13 ist mit einem Source-Anschluss des Halbleiterschalters 3, insbesondere mittels Löten, verbunden.

Die durch das Abwinkeln des Ausgangsanschlusses 13 gebildete weitere Treppenstufe liegt dem Flächenabschnitt 11 gegenüber, wobei der Halbleiterschalter 4 in einem Zwischenraum zwischen dem Flächenabschnitt 11 und dem zuvor beschriebenen Treppenabschnitt des Ausgangsanschlusses 13 angeordnet ist. Der Ausgangsanschluss 13 ist mit einem Drain-Anschluss des Halbleiterschalters 4, insbesondere mittels Löten, verbunden. Die Source- und Drain-Anschlüsse der Halbleiterschalter 3 und 4 sind jeweils durch einander gegenüberliegende, und entgegengesetzt zueinander abweisende Oberflächen der Halbleiterschalter gebildet. Die Halbleiterschalter 3 und 4 sind in dieser Ausführungsform in einer gemeinsamen Ebene angeordnet. Auf diese Weise kann das Leistungsmodul 1 kompakt ausgebildet sein. Der Ausgangsanschluss 13 ragt mit einem Endabschnitt aus dem Leistungsmodul 1 heraus.

Steueranschlüsse, insbesondere Gate-Anschlüsse der Halbleiterschalter 3 und 4, können in einen Zwischenraum zwischen den Flächenabschnitten und dem Ausgangsanschluss hineinragen. Die Steueranschlüsse der Halbleiterschalter sind in Figur 1 nicht dargestellt.

Der Ausgangsanschluss 13 kann mit dem Endabschnitt mit einem Stator einer elektrischen Maschine, beispielsweise eines Elektromotors eines Elektrofahrzeuges, verbunden werden.

Die negative Kontaktschiene 6 weist auch einen entlang der Längserstreckung 40 abgewinkelten Längsabschnitt 12 auf, welcher in diesem Ausführungsbeispiel in einer Ebene des eine Treppenstufe bildenden Flächenabschnitts des Ausgangsanschlusses 13 bildet, der mit dem Halbleiterschalter 4 verbunden ist. Die Kontaktschienen 6 und 7 sind mit den abgewinkelten Flächenabschnitten 10 und 12 mit einem Kühlelement 18 thermisch leitend und elektrisch isoliert verbunden. Dazu ist zwischen dem Kühlelement 18 und den Flächenabschnitten 10 und 12 eine elektrische Isolationsschicht 16 ausgebildet. Die Isolationsschicht 16 kann beispielsweise durch eine Polyimid-Folie oder Polyamidfolie gebildet sein. Der zuvor beschriebene Flächenabschnitt des Ausgangsanschlusses 13, welcher mit dem Halbleiterschalter 4 verbunden ist, ist wie der Flächenabschnitt 12 über die Isolationsschicht 16 mit dem Kühlelement 18 verbunden. Das Kühlelement 18 ist in diesem Ausführungsbeispiel als quaderförmiger Block, insbesondere Aluminiumblock ausbildet. Das Kühlelement 18 weist in diesem Ausführungsbeispiel drei röhrenförmig ausgebildete Hohlräume 20, 21 und 22 auf, welche jeweils zum Führen eines Fluids, insbesondere Kühlwasser ausgebildet sind. So kann eine in dem Leistungsmodul 1 erzeugte Verlustwärme, insbesondere eine Verlustwärme der Halbleiterschalter 3 und 4, weiter eine in einem Energiespeicher 8, insbesondere einem Wickelkondensator erzeugte Verlustwärme, von dem Kühlelement 18 aufgenommen und abgeführt werden.

Das Leistungsmodul 1 weist auch einen Energiespeicher 8 auf, welcher in diesem Ausführungsbeispiel als Wickelkondensator ausgebildet ist. Stirnseiten des Energiespeichers 8 sind in diesem Ausführungsbeispiel als elektrische Anschlüsse ausgebildet. Die elektrischen Anschlüsse des Energiespeichers 8 sind in diesem Ausführungsbeispiel als elektrisch leitfähige Schicht, insbesondere Schoopschicht ausgebildet. Dargestellt ist die elektrisch leitfähige Schicht 26 eines negativen Anschlusses des Energiespeichers 8, und eine elektrisch leitfähige Schicht 25 eines positiven Anschlusses des Energiespeichers 8. Die elektrisch leitfähige Schicht 26 ist in diesem Ausführungsbeispiel beispielhaft mittels in der Kontaktschiene 6 mittels Stanzen erzeugten, L-förmigen Kontaktzungen mittels Schweißen verbunden. Die L-förmige Kontaktzunge 50 ist beispielhaft bezeichnet. Die L-förmige Kontaktzunge 50 bewirkt, dass die elektrische Verbindung, insbesondere Schweißverbindung zwischen der Kontaktschiene 6 und der elektrisch leitfähigen Schicht 26 bei thermischen Ausdehnungen des Energiespeichers 8 nicht reißt, da die Kontaktzungen, welche insbesondere im Bereich eines Endes der L-Form mit der elektrisch leitfähigen Schicht 26 verbunden ist, beim thermischen Ausdehnen des Energiespeichers 8 relativ zur Kontaktschiene 6 in zueinander verschiedenen Freiheitsgraden bewegt werden kann.

Der Energiespeicher 8 ist beispielsweise als Wickelkondensator ausgebildet. Das Leistungsmodul 1 weist in diesem Ausführungsbeispiel noch einen weiteren Energiespeicher 9 auf, welcher - wie der Energiespeicher 8 - von entsprechend ausgebildeten Kontaktschienen elektrisch kontaktiert ist. Die Kontaktschienen 6 und 7 bilden mit den abgewinkelten Flächenabschnitten 10 beziehungsweise 11 eine Rinne, in welcher der Energiespeicher 8 aufgenommen ist. Der Energiespeicher 9 ist mit seinen Kontaktschienen entlang der Längserstreckung 40 zu dem Energiespeicher 8 benachbart angeordnet. Auf diese Weise kann das Leistungsmodul 1 vorteilhaft aus mehreren Teilmodulen gebildet sein, wobei jedes Teilmodul einen Energiespeicher und eine mit dem Energiespeicher verbundene Halbleiterschalter-Halbbrücke aufweist.

Das Teilmodul umfassend den Energiespeicher 9 weist eine Leistungsendstufe auf, deren Ausgangsanschluss 14 dargestellt ist. Die Leistungsendstufe des Teilmoduls mit dem Energiespeicher 9 weist zwei Halbleiterschalter auf, welche wie die Halbleiterschalter 3 und 4 mit dem Ausgangsanschluss 14 und den Kontaktschienen des Energiespeichers 9 verbunden sind.

Die Kontaktschiene 6 weist in diesem Ausführungsbeispiel quer zur Längserstreckung 40 abweisende Vorsprungsbereiche 46 und 48 auf, welche ausgebildet sind, von einer Schiene mit entsprechenden Aussparungen elektrisch und formschlüssig kontaktiert zu werden. Die Vorsprungsbereiche 46 und 48 sind in diesem Ausführungsbeispiel als rechteckig, insbesondere gestanzte Zungen ausgebildet, welche jeweils ausgebildet sind, in entsprechende, beispielsweise schlitzförmige Aussparungen einer Stromschiene einzugreifen. Die Vorsprungsbereiche 46 und 48 können in einer weiteren Fortbildung als Schneid-Klemmkontakte ausgebildet sein. Die Vorsprünge weisen dann - wie in Figur 1 dargestellt - eine U-förmige Aussparung auf, welche ausgebildet ist, einen Draht oder einen Vorsprungsbereich der zuvor erwähnten Stromschiene aufzunehmen.

Die Kontaktschiene 7 weist zwei Vorsprungsbereiche 42 und 44 auf, welche wie die Vorsprungsbereiche 46 und 48 ausgebildet und an die Kontaktschiene 7 angeformt sind. Mittels der Vorsprungsbereiche der Kontaktschienen, welche in diesem Ausführungsbeispiel Anschlüsse des Zwischenkreiskondensators 8 bilden, kann der Zwischenkreiskondensator 8 mit einem Zwischenkreis, beispielsweise einem Hochvoltnetz eines Elektrofahrzeuges, elektrisch verbunden werden. Die zuvor erwähnte Stromschiene kann dazu die Kontaktschienen der Energiespeicher 8 und 9, beispielsweise auch die Kontaktschienen weiterer Energiespeicher des Leistungsmoduls, elektrisch miteinander verbinden.

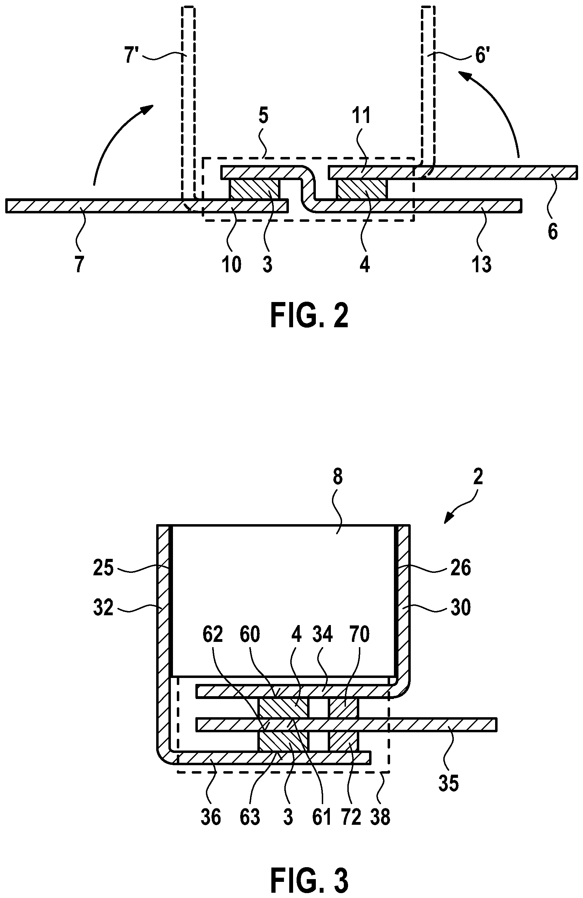

Figur 2 zeigt die Kontaktschienen 6 und 7 des in Figur 1 bereits dargestellten Leistungsmoduls, und ein Verfahren zu deren Herstellung. Die Halbleiterschalter 3 und 4 sind beispielsweise in einem ersten Schritt mit den Flächenabschnitten der Kontaktschienen 6 beziehungsweise 7 mittels Löten verbunden worden. Die Halbleiterschalter 3 und 4 sind auch jeweils zum Erzeugen einer Halbbrücke mit dem in Figur 1 bereits dargestellten Ausgangsanschluss 13 mittels Löten verbunden. Die Halbleiterschalter 3 und 4 sind zusammen mit den Flächenabschnitten 10 und 11 in diesem Ausführungsbeispiel in einem weiteren Schritt in einem Kunststoffkörper 5 eingebettet.

Die Halbbrücke, umfassend die Halbleiterschalter 3 und 4, bildet somit in diesem Ausführungsbeispiel ein Mold-Modul. Die Kontaktschienen 6 und 7 sind bis zum Einbetten in den Kunststoffkörper beispielsweise zusammen mit den Flächenabschnitten 10 beziehungsweise 11 jeweils als sich flach erstreckendes, gestanztes Blech ausgebildet. Die Kontaktschienen 6 und 7 ragen jeweils aus dem Mold-Modul, insbesondere dem Kunststoffkörper 5 heraus. Die Kontaktschiene 6 kann dann in einem weiteren Schritt abgewinkelt werden, insbesondere entlang der in Figur 1 dargestellten Längserstreckung 40 des Leistungsmoduls 1. Die abgewinkelte Stellung 6' der Kontaktschiene 6 ist gestrichelt gekennzeichnet. Die Kontaktschiene 7 wird - wie die Kontaktschiene 6 - abgewinkelt und ist in der abgewinkelten Position 7' dargestellt. In einem weiteren Schritt kann dann der in Figur 1 dargestellte Energiespeicher in die so mittels der Kontaktschienen gebildete Rinne eingefügt, und in einem weiteren Schritt mit den Kontaktschienen elektrisch verbunden werden.

Figur 3 zeigt ein Ausführungsbeispiel für ein Leistungsmodul 2. Das Leistungsmodul 2 umfasst zwei Kontaktschienen, nämlich eine negative Kontaktschiene 30 und eine positive Kontaktschiene 32. Das Leistungsmodul 2 weist auch einen Energiespeicher 8 mit einer elektrisch leitfähigen Schicht 26 eines negativen Anschlusses des Energiespeichers 8, und eine elektrisch leitfähige Schicht 25 eines positiven Anschlusses des Energiespeichers 8. Die positive Kontaktschiene 32 ist mit der elektrisch leitfähigen Schicht 25 verbunden. Die negative Kontaktschiene 30 ist mit der elektrisch leitfähigen Schicht 26 verbunden. Die positive Kontaktschiene 32 ist abgewinkelt und bildet mit dem abgewinkelten Flächenabschnitt einen Anschluss, der mit dem Halbleiterschalter 3, und dort mit einer Anschlussfläche 63, insbesondere einem Drain-Anschluss des Halbleiterschalters 3, elektrisch, beispielsweise mittels Löten, verbunden ist.

Die Kontaktschiene 30 weist einen abgewinkelten Flächenabschnitt 34 auf, welcher dem abgewinkelten Flächenabschnitt 36 der Kontaktschiene 32 sich parallel zur Kontaktschiene 36 erstreckend gegenüber liegt. Die negative Kontaktschiene 30 bildet mit dem abgewinkelten Flächenabschnitt 34 einen Anschluss, der mit dem Halbleiterschalter 4, und dort mit einer Anschlussfläche 60, insbesondere einem Source-Anschluss des Halbleiterschalters 4, elektrisch, beispielsweise mittels Löten, verbunden ist.

Der Flächenabschnitt Die Flächenabschnitte 34 und 36 schließen zusammen einen Hohlraum ein, in dem die Halbleiterschalter 3 und 4 angeordnet sind. Zwischen den Halbleiterschaltern 3 und 4 ist ein Ausgangsanschluss 35 angeordnet, wobei der Halbleiterschalter 4 mit einer Anschlussfläche 61, insbesondere einem Drain-Anschluss mit dem Ausgangsanschluss 35, und der Halbleiterschalter 3 mit einer Anschlussfläche 62, insbesondere einem Source-Anschluss mit dem Ausgangsanschluss 35 verbunden ist. Der Ausgangsanschluss 35 ist in diesem Ausführungsbeispiel als ein sich flach erstreckendes Blech gebildet.

In dem zwischen dem Flächenabschnitt 34 und dem Ausgangsanschluss 35 gebildeten Hohlraum ist zusätzlich zu dem Halbleiterschalter 4 eine Gleichrichterdiode 70 angeordnet die zu einer Schaltstrecke des Halbleiterschalters 4 parallel geschaltet ist. In dem zwischen dem Flächenabschnitt 36 und dem Ausgangsanschluss 35 gebildeten Hohlraum ist zusätzlich zu dem Halbleiterschalter 3 eine Gleichrichterdiode 72 angeordnet, die zu einer Schaltstrecke des Halbleiterschalters 3 parallel geschaltet ist. Der Energiespeicher 8 kann mittels der Gleichrichterdioden 70 und 72 - beispielsweise in einem Rekuperationsbetrieb - geladen werden. Die Anschlüsse der Gleichrichterdioden 70 und 72 sind jeweils durch zueinander parallele Oberflächenbereiche der Gleichrichterdiode 70 beziehungsweise 72 gebildet.

Die Halbleiterschalter 3 und 4, welche beispielsweise als MOS-FET-Transistoren ausgebildet sind, sind in diesem Ausführungsbeispiel zusammen mit den Flächenabschnitten 34 und 36, weiter mit einem Abschnitt des Ausgangsanschlusses 35 von einer Kunststoffmasse 38 umgeben und bilden zusammen mit der Kunststoffmasse 38 eine Halbbrücke einer Leistungsendstufe. Die Kunststoffmasse 38 ist beispielsweise durch einen Duroplast, insbesondere Polyamid oder Bakelit gebildet. Die auf diese Weise ein Mold-Modul bildende Leistungsendstufe - beispielsweise zum Bestromen einer Statorspule einer elektrischen Maschine - ist beispielsweise mittels Spritzgießen erzeugt.

## Patentansprüche

1. Leistungsmodul (1, 2) für eine elektrische Maschine,
mit einer wenigstens einen Halbleiterschalter (3, 4) umfassenden Leistungsendstufe (5), wobei das Leistungsmodul (1, 2) einen Energiespeicher (8, 9) umfasst, wobei die Leistungsendstufe (5) eingangsseitig mit dem elektrischen Energiespeicher (8, 9) verbunden ist, und der Energiespeicher (8, 9) einen positiven Anschluss (25) aufweist der mit einer positiven Kontaktschiene (7) verbunden ist und einen negativen Anschluss (26) aufweist, der mit einer negativen Kontaktschiene (6) verbunden ist, wobei wenigstens ein Flächenabschnitt (10, 11) der Kontaktschienen (6, 7) jeweils mit einer Anschlussfläche des wenigstens einen der Halbleiterschalters (3, 4) elektrisch verbunden ist, wobei die Kontaktschienen jeweils als elektrisch leitfähiges Blech ausgebildet sind, wobei die Leistungsendstufe zwei Halbleiterschalter (3, 4) aufweist, die gemeinsam eine Halbbrücke bilden, wobei die Halbleiterschalter (3, 4) gehäuselos ausgebildet sind und eine Quaderform aufweisen, und wobei bei jedem Halbleiterschalter die Anschlüsse einer Schaltstrecke des Halbleiterschalters (3, 4) jeweils durch einander gegenüberliegende Oberflächenbereiche des Halbleiterschalters (3, 4) gebildet sind, und der High-Side-Halbleiterschalter (3) der Halbbrücke mit einem Anschluss (63) mit dem Flächenabschnitt (36, 10) der positiven Kontaktschiene (7, 32) verbunden ist und der Low-Side-Halbleiterschalter (4) der Halbbrücke mit dem Flächenabschnitt (11, 34) der negativen Kontaktschiene (6, 30) verbunden ist, wobei das Leistungsmodul (1, 2) einen Ausgangsanschluss (13, 14, 35) aufweist, der mit einem Ausgang (61, 62) der Halbbrücke (3, 4) verbunden ist, wobei der Ausgangsanschluss (13, 14, 35) mit einem Flächenabschnitt mit dem High-Side-Halbleiterschalter (3) verbunden ist und mit demselben oder einem weiteren Flächenabschnitt mit dem Low-Side-Halbleiterschalter (4) verbunden ist, wobei der High-Side-Halbleiterschalter (3) zwischen dem Flächenabschnitt des Ausgangsanschlusses (13, 14, 35) und dem Flächenabschnitt (10) der positiven Kontaktschiene (7) angeordnet ist wobei der Low-Side-Halbleiterschalter (4) zwischen demselben oder dem weiteren Flächenabschnitt des Ausgangsanschlusses (13, 14, 35) und dem Flächenabschnitt (11) der negativen Kontaktschiene (6) angeordnet ist, wobei die positive Kontaktschiene (7) und die negative Kontaktschiene (6) einen Hohlraum einschließen, in dem der Energiespeicher (8, 9) wenigstens teilweise oder vollständig aufgenommen ist, und mittels der Kontaktschienen (6, 7) eine Rinne gebildet ist, wobei der Energiespeicher (8, 9) wenigstens teilweise oder vollständig in der Rinne aufgenommen ist, und der Flächenabschnitt (10, 11) der Kontaktschiene (6, 7) durch einen entlang einer Längserstreckung (40) der Kontaktschiene (6, 7) abgewinkelten Abschnitt der Kontaktschiene (6, 7) gebildet ist, und wobei der abgewinkelte Flächenabschnitt (10, 11) sowohl einen Rinnenboden der Rinne bildet, in welcher der Energiespeicher (8, 9) aufgenommen ist, als auch eine elektrische Verbindungsleitung zu dem Halbleiterschalter (3, 4) hin.

2. Leistungsmodul (1, 2) nach Anspruch 1,
**dadurch gekennzeichnet, dass**
wobei der positive Anschluss und der negative Anschluss des Energiespeichers jeweils als elektrisch leitfähige Schicht ausgebildet sind, und die Kontaktschienen jeweils an mehreren Kontaktorten mit der elektrisch leitfähigen Schicht verbunden sind.

3. Leistungsmodul (1, 2) nach Anspruch 1 oder 2,
**dadurch gekennzeichnet, dass**
die Kontaktschienen (30, 32) jeweils mit dem Flächenabschnitt (34, 36) zueinander beabstandet überlappen und einen Zwischenraum miteinander einschließen, wobei beide Halbleiterschalter (3, 4) in dem Zwischenraum eingeschlossen sind und, bei jedem Halbleiterschalter, wenigstens ein Anschluss (60, 63) des Halbleiterschalters (3, 4) mit wenigstens einer Kontaktschiene (30, 32) elektrisch leitfähig verbunden ist.

4. Leistungsmodul (1, 2) nach einem der vorhergehenden Ansprüche,
**dadurch gekennzeichnet, dass**
das Leistungsmodul (1, 2) zwei Dioden (70, 72) umfasst, wobei jede Diode zu einer Schaltstrecke des jeweiligen Halbleiterschalters (3, 4) parallel geschaltet ist wobei Jede Diode (70, 72) eine Gleichrichterdiode ist, welche in dem zwischen dem Flächenabschnitt (34) und dem Ausgangsanschluss (35, 36) gebildeten Hohlraum ist zusätzlich zu dem jeweiligen Halbleiterschalter (3, 4) angeordnet ist.

5. Leistungsmodul (1, 2) nach einem der vorhergehenden Ansprüche,
**dadurch gekennzeichnet, dass**
das Leistungsmodul (1, 2) mit einem Kühlelement (18) wärmeleitend verbunden ist, wobei wenigstens ein Flächenabschnitt (10, 12) einer Kontaktschiene (6, 7) oder zusätzlich ein Flächenabschnitt des Ausgangsanschlusses (13, 14) mit dem Kühlelement (18) wärmeleitend verbunden ist, so dass sowohl von dem Energiespeicher über die elektrisch leitfähigen Kontaktschienen Wärme in das Kühlelement abgeführt werden kann, als auch von der Leistungsendstufe über die Flächenabschnitte der Kontaktschienen Wärme in das Kühlelement fließen kann.

6. Leistungsmodul, das mehrere Leistungsmodule nach einem der Ansprüche 1-4 umfasst, wobei die mehreren Leistungsmodule entlang einer Längserstreckung (40) zueinander benachbart angeordnet sind.

## Claims

1. Power module (1, 2) for an electric machine, having a power output stage (5) comprising at least one semiconductor switch (3, 4), wherein the power module (1, 2) comprises an energy store (8, 9), wherein the input side of the power output stage (5) is connected to the electrical energy store (8, 9), and the energy store (8, 9) has a positive connection (25), which is connected to a positive contact rail (7), and a negative connection (26), which is connected to a negative contact rail (6), wherein at least one surface-area section (10, 11) of the contact rails (6, 7) is electrically connected in each case to a connection surface area of the at least one of the semiconductor switch (3, 4), wherein the contact rails are each formed as an electrically conductive plate, wherein the power output stage has two semiconductor switches (3, 4), which together form a half-bridge, wherein the semiconductor switches (3, 4) are formed without a housing and have a cuboid form, and wherein, in each semiconductor switch, the connections of a switching path of the semiconductor switch (3, 4) are each formed by surface regions of the semiconductor switch (3, 4) that are opposite one another, and the high-side semiconductor switch (3) of the half-bridge is connected by way of a connection (63) to the surface-area section (36, 10) of the positive contact rail (7, 32) and the low-side semiconductor switch (4) of the half-bridge is connected to the surface-area section (11, 34) of the negative contact rail (6, 30), wherein the power module (1, 2) has an output connection (13, 14, 35), which is connected to an output (61, 62) of the half-bridge (3, 4), wherein the output connection (13, 14, 35) is connected by way of a surface-area section to the high-side semiconductor switch (3) and is connected by way of the same or a further surface-area section to the low-side semiconductor switch (4), wherein the high-side semiconductor switch (3) is arranged between the surface-area section of the output connection (13, 14, 35) and the surface-area section (10) of the positive contact rail (7), wherein the low-side semiconductor switch (4) is arranged between the same or the further surface-area section of the output connection (13, 14, 35) and the surface-area section (11) of the negative contact rail (6), wherein the positive contact rail (7) and the negative contact rail (6) enclose a cavity in which the energy store (8, 9) is at least partly or fully received, and a groove is formed by means of the contact rails (6, 7), wherein the energy store (8, 9) is at least partly or fully received in the groove, and the surface-area section (10, 11) of the contact rail (6, 7) is formed by a section of the contact rail (6, 7) that is angled away along a longitudinal extent (40) of the contact rail (6, 7), and wherein the angled-away surface-area section (10, 11) forms both a groove base of the groove in which the energy store (8, 9) is received and an electrical connection line to the semiconductor switch (3, 4).

2. Power module (1, 2) according to Claim 1,
**characterized in that**
wherein the positive connection and the negative connection of the energy store are each formed as an electrically conductive layer, and the contact rails are each connected to the electrically conductive layer at a plurality of contact locations.

3. Power module (1, 2) according to Claim 1 or 2,
**characterized in that**
the contact rails (30, 32) each overlap with the surface-area section (34, 36) at a distance from one another and enclose an intermediate space with one another, wherein both semiconductor switches (3, 4) are enclosed in the intermediate space and, in each semiconductor switch, at least one connection (60, 63) of the semiconductor switch (3, 4) is electrically conductively connected to at least one contact rail (30, 32).

4. Power module (1, 2) according to one of the preceding claims,
**characterized in that**
the power module (1, 2) comprises two diodes (70, 72), wherein each diode is connected in parallel with a switching path of the respective semiconductor switch (3, 4), wherein each diode (70, 72) is a rectifier diode, which, is in addition to the respective semiconductor switch (3, 4), is arranged in the cavity formed between the surface-area section (34) and the output connection (35, 36).

5. Power module (1, 2) according to one of the preceding claims,
**characterized in that**
the power module (1, 2) is thermally conductively connected to a cooling element (18), wherein at least one surface-area section (10, 12) of a contact rail (6, 7) or additionally a surface-area section of the output connection (13, 14) is thermally conductively connected to the cooling element (18) so that heat can be dissipated into the cooling element both from the energy store via the electrically conductive contact rails and heat can flow from the power output stage into the cooling element via the surface-area sections of the contact rails.

6. Power module, which comprises a plurality of power modules according to one of Claims 1-4, wherein the plurality of power modules are arranged adjacent to one another along a longitudinal extent (40).

## Revendications

1. Module de puissance (1, 2) pour une machine électrique, comportant un étage terminal de puissance (5) comprenant au moins un commutateur à semi-conducteurs (3, 4), dans lequel le module de puissance (1, 2) comprend un accumulateur d'énergie (8, 9), dans lequel l'étage terminal de puissance (5) est relié côté entrée à l'accumulateur d'énergie électrique (8, 9), et l'accumulateur d'énergie (8, 9) présente une borne positive (25) qui est reliée à un rail de contact positif (7) et présente une borne négative (26) qui est reliée à un rail de contact négatif (6), dans lequel au moins un segment de surface (10, 11) des rails de contact (6, 7) est respectivement relié électriquement à une surface de connexion dudit au moins un des commutateur à semi-conducteurs (3, 4), dans lequel les rails de contact sont respectivement réalisés sous la forme d'une tôle électriquement conductrice, dans lequel l'étage terminal de puissance comporte deux commutateurs à semi-conducteurs (3, 4) qui forment ensemble un demi-pont, dans lequel les commutateurs à semi-conducteurs (3, 4) sont réalisés sans boîtier et présentent une forme cubique, et dans lequel, pour chaque commutateur à semi-conducteurs, les bornes d'un trajet de commutation du commutateur à semi-conducteurs (3, 4) sont respectivement formées par des zones de surface opposées du commutateur à semi-conducteurs (3, 4), et le commutateur à semi-conducteurs côté haut (3) du demi-pont est relié par une borne (63) au segment de surface (36, 10) du rail de contact positif (7, 32) et le commutateur à semi-conducteurs côté bas (4) du demi-pont est relié au segment de surface (11, 34) du rail de contact négatif (6, 30), dans lequel le module de puissance (1, 2) comporte une borne de sortie (13, 14, 35) reliée à une sortie (61, 62) du demi-pont (3, 4), dans lequel la borne de sortie (13, 14, 35) est reliée par un segment de surface au commutateur à semi-conducteurs côté haut (3) et est reliée par le même segment de surface ou un autre segment de surface au commutateur à semi-conducteurs côté bas (4), dans lequel le commutateur à semi-conducteurs côté haut (3) est disposé entre le segment de surface de la borne de sortie (13, 14, 35) et le segment de surface (10) du rail de contact positif (7), dans lequel le commutateur à semi-conducteurs côté bas (4) est disposé entre le même ou l'autre segment de surface de la borne de sortie (13, 14, 35) et le segment de surface (11) du rail de contact négatif (6), dans lequel le rail de contact positif (7) et le rail de contact négatif (6) enserrent une cavité dans laquelle l'accumulateur d'énergie (8, 9) est logé au moins en partie ou en totalité et un canal est formé au moyen des rails de contact (6, 7), dans lequel l'accumulateur d'énergie (8, 9) est logé au moins en partie ou en totalité dans le canal, et le segment de surface (10, 11) du rail de contact (6, 7) est formé par un segment du rail de contact (6, 7) qui est coudé suivant une extension longitudinale (40) du rail de contact (6, 7), et dans lequel le segment de surface coudé (10, 11) forme à la fois un fond de canal du canal dans lequel est logé l'accumulateur d'énergie (8, 9) et une ligne de connexion électrique au commutateur à semi-conducteurs (3, 4).

2. Module de puissance (1, 2) selon la revendication 1, **caractérisé en ce que** dans lequel la borne positive et la borne négative de l'accumulateur d'énergie sont respectivement réalisées sous la forme d'une couche électriquement conductrice, et les rails de contact sont respectivement reliés à la couche électriquement conductrice en plusieurs points de contact.

3. Module de puissance (1, 2) selon la revendication 1 ou 2, **caractérisé en ce que** les rails de contact (30, 32) chevauchent respectivement le segment de surface (34, 36) de manière espacée l'un de l'autre et enserrent un espace intermédiaire l'un avec l'autre, dans lequel les deux commutateurs à semi-conducteurs (3, 4) sont contenus dans l'espace intermédiaire et, pour chaque commutateur à semi-conducteurs, au moins une borne (60, 63) du commutateur à semi-conducteurs (3, 4) est reliée de manière électriquement conductrice à au moins un rail de contact (30, 32).

4. Module de puissance (1, 2) selon l'une des revendications précédentes, **caractérisé en ce que** le module de puissance (1, 2) comprend deux diodes (70, 72), dans lequel chaque diode est connectée en parallèle à un trajet de commutation du commutateur à semi-conducteurs (3, 4) respectif,
dans lequel chaque diode (70, 72) est une diode de redressement qui est disposée dans la cavité formée entre le segment de surface (34) et la borne de sortie (35, 36), est en plus du commutateur à semi-conducteurs (3, 4) respectif.

5. Module de puissance (1, 2) selon l'une des revendications précédentes, **caractérisé en ce que** le module de puissance (1, 2) est relié de manière thermiquement conductrice à un élément de refroidissement (18), dans lequel au moins un segment de surface (10, 12) d'un rail de contact (6, 7) ou en outre un segment de surface de la borne de sortie (13, 14) est relié de manière thermiquement conductrice à l'élément de refroidissement (18) de manière à ce que non seulement la chaleur puisse être dissipée depuis l'accumulateur d'énergie vers l'élément de refroidissement par l'intermédiaire des rails de contact électriquement conducteurs mais également que la chaleur puisse circuler dans l'élément de refroidissement depuis l'étage terminal de puissance par l'intermédiaire des segments de surface des rails de contact.

6. Module de puissance comprenant une pluralité de modules de puissance selon l'une des revendications 1 à 4, dans lequel la pluralité de modules de puissance sont agencés de manière adjacente les uns aux autres suivant une extension longitudinale (40).
